(19) **Europäisches Patentamt**

**European Patent Office**

**Office européen des brevets**

(11) **EP 0 762 500 B1**

(12) **EUROPÄISCHE PATENTSCHRIFT**

(45) Veröffentlichungstag und Bekanntmachung des Hinweises auf die Patenterteilung:
**24.10.2001 Patentblatt 2001/43**

(51) Int Cl.[7]: **H01L 27/06**, H01L 21/8252, H01L 29/868

(21) Anmeldenummer: **96113671.0**

(22) Anmeldetag: **27.08.1996**

(54) **Planare PIN-Diode und Verfahren zu deren Herstellung**

Planar PIN diode and method of manufacturing the same

Diode PIN plane et méthode de fabrication

(84) Benannte Vertragsstaaten:
**DE FR GB IT**

(30) Priorität: **08.09.1995 DE 19533206**

(43) Veröffentlichungstag der Anmeldung:
**12.03.1997 Patentblatt 1997/11**

(73) Patentinhaber: **DaimlerChrysler AG**
**70567 Stuttgart (DE)**

(72) Erfinder: **Brugger, Hans**
**D-89250 Senden (DE)**

(74) Vertreter: **Fröhling, Werner Otto, Dr. et al**
**DaimlerChrysler AG,**
**Intellectual Property Management,**
**Sedanstr. 10/Gebäude 17**
**89077 Ulm (DE)**

(56) Entgegenhaltungen:
**EP-A- 0 417 348       US-A- 5 371 399**

- **MICROWAVE AND MILLIMETER WAVE MONOLITHIC CIRCUITS SYMPOSIUM, NEW YORK, MAY 24 - 25, 1988, Nr. 1988, 24.Mai 1988, DAWSON D E, Seiten 147-150, XP000043056 SEYMOUR D J ET AL: "X-BAND AND KA-BAND MONOLITHIC GAAS PIN DIODE VARIABLE ATTENUATION LIMITERS"**
- **MICROELECTRONIC ENGINEERING, Bd. 15, Nr. 1 / 04, 1.Oktober 1991, Seiten 271-274, XP000292765 ALLAN D A ET AL: "PLANAR INTEGRATION TECHNOLOGIES FOR OPTOELECTRONIC INTEGRATED CIRCUITS"**
- **SMITH F W; ET AL: "NEW MBE BUFFER USED TO ELIMINATE BACKGATING IN GAAS MESFET'S ", IEEE ELECTRON DEVICE LETTERS, NEW YORK, USA, 01. Februar 1988, Band 9, Nr. 2, Seiten 77 - 80**
- **SMITH F W; ET AL: "NEW MBE BUFFER USED TO ELIMINATE BACKGATING IN GAAS MESFET'S", IEEE ELECTRON DEVICE LETTERS, NEW YORK, USA, 01. Februar 1988, Band 9, Nr. 2, Seiten 77 - 80**

Anmerkung: Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist. (Art. 99(1) Europäisches Patentübereinkommen).

**Beschreibung**

Die Erfindung betrifft ein Verfahren und eine PIN-Diode nach den Oberbegriffen der Patentansprüche 1 und 4.

In Sensor-, Kommunikations-, und Radarsystemen im Anwendungsbereich der Milimeterwellenfrequenzen werden im allgemeinen bipolare PIN-Dioden, die aus einem löcherleitenden (P) Halbleiterbereich, einem intrinsischen (I), d.h. nominell undotierten Halbleiterbereich und einem elektronenleitenden (N) Halbleiterbereich bestehen, für Schalteranwendungen zur Strahlsteuerung in T/R-Modulen (Transmitter/Receiver) eingesetzt und als gesteuerte Hochfrequenz (HF) Dämpfungsglieder verwendet. Ferner werden derartige Elemente als schnelle Begrenzer-/ Schutzdioden für empfindliche Empfangskomponenten in, z.B. parametrischen Verstärker-, Mischer- und Detektor-Schaltkreisen eingesetzt. Dabei kommen PIN-Dioden in Form von Einzelbauelementen oder in Form von monolithisch integrierten Schaltungen (MMICs) zum Einsatz, die zusätzliche passive Komponenten, wie Kapazitäten, Induktivitäten und Widerstände, enthalten können.

Ein Nachteil der bipolaren PIN-Dioden sind die Schaltgeschwindigkeiten, die auf Werte von einigen Nanosekunden begrenzt sind.

Für schnelle Anwendungen zur Strahlsteuerung in HF T/R-Modulen und zum Schalten von Mehrfachantennenkanälen sind PIN-Dioden mit möglichst kurzen Schaltzeiten vom Sperr- in den Durchlaßbereich (Einschaltvorgang, on-state) und vom Durchlaßbereich in den Sperrbereich (Ausschaltvorgang, off-state) von Vorteil. Letzterer ist normalerweise der langsamere Vorgang. In Durchlaßrichtung ist die Diode im intrinsischen (I) Halbleiterbereich zwischen den P- und N-leitenden Kontaktzonen mit Löchern und Elektronen hoher Dichte überschwemmt. Während des Ausschaltvorgangs muß der I-Bereich möglichst schnell von Ladungsträgern ausgeräumt werden. Die Ausschaltzeit ist durch die Ladungsträgerlebensdauer und die Transitzeit bestimmt. Abgesehen von PIN-Dioden mit extrem hohen Sperrspannungen und somit weiten I-Zonen ist die Ladungsträgerlebensdauer der dominante Term in der Ausschaltzeit. Deshalb kommt der Reduzierung der Ladungsträgerlebensdauer hinsichtlich einer Reduzierung der Ausschaltzeit eine besondere Bedeutung zu.

Wegen der langen Ladungsträgerlebensdauer in Silizium (Si) dauert der Ausschaltvorgang von Si PIN-Dioden entsprechend lange im Vergleich zu PIN-Dioden auf der Basis von Galliumarsenidmaterial (GaAs), wie aus einer Veröffentlichung von A. Klassen, J. M. Dieudonne in IEEE MTT-S Digest 1995, S. 1631-1634, bekannt ist. Deshalb sind bevorzugt GaAs PIN-Dioden prädestiniert für schnelle Anwendungen in HF-Systemen (siehe G. H. Nebit et al. GaAs IC Symposium 1987, S. 147-150; D. Payne et al. GaAs IC Symposium 1989, S. 177-180). Für Schalterbauelemente in Form von PIN-Dioden sind neben den Schaltzeiten noch die folgenden Leistungsmerkmale wichtig:

- Geringe Einfügungsdämpfung im Durchlaßbereich
- Hohe Isolation im Sperrbereich
- Hohe Leistungsverträglichkeit in beiden Schalterzuständen (on-state und off-state).

Bisher haben sich für Millimeterwellenanwendungen im wesentlichen PIN-Dioden mit einer vertikalen Halbleiterschichtanordnung kommerziell behauptet, die, für z.B. Single-Pole Double-Throw (SPDT) oder Single-Pole Three-Throw (SP3T) Schalter mehrere Dioden auf einem Chip angeordnet haben und die einzelnen PIN-Dioden als Mesadioden ausgebildet sind. Dadurch sind sie elektrisch voneinander isoliert und weisen geringe parasitäre Elemente auf. Allerdings ist das Herstellungsverfahren für eine vertikale PIN-Diode aufwendig und teuer. Die vertikal angeordneten P, I und N-Zonen werden mit epitaktischen Methoden, üblicherweise Gasphasenepitaxie (z.B. MOCVD), hergestellt. Die üblicherweise notwendigen, hohen Durchbruchspannungen der PIN-Diode erfordern eine I-Zone, die einige Mikrometer dick ist, zuzüglich der N- und P-leitenden Bereiche mit insgesamt mindestens 1µm Dicke. Dies führt zu einer insgesamt nicht-planaren Struktur von etwa 5 µm bis 10 µm Höhe und erfordert eine Luftbrückentechnologie für die Kontaktierung des obenaufliegenden ohmschen Kontakts auf der Mesa.

Planare PIN-Dioden mit lateral angeordneten P-, I- und N-Bereichen, strukturiert in einem einheitlichen Substratmaterial, sind in der Veröffentlichung von Seymour et al.; Microwave and Millimeter-Wave Monolithic Circuits Symposiom, New York, May 24-25, 1988 beschrieben, die als monolithische GaAs-Bauelemente in Schaltkreisen von Radarempfängern eingesetzt werden.

Ein kostengünstiges Verfahren für die Realisierung einer planaren PIN-Diode mit lateral angeordneten P-, I- und N-Bereichen ist in der Veröffentlichung von G. H. Nebit et al. beschrieben. Dabei werden keine Epitaxieverfahren, Mesastrukturen und Luftbrückentechnologien verwendet. Als Ausgangsmaterial wird eine halbisolierende GaAs Halbleitersubstratscheibe benutzt, in die direkt die P- und N-leitenden Halbleiterbereiche mit einer Implantationstechnik erzeugt werden. Die I-Zone wird aus dem hochohmigen und kompensierten Material der GaAs-Substratscheibe zwischen den P- und N-Bereichen gebildet. Allerdings ist aufgrund der hohen Störstellendichte in hochohmigen Substratscheiben die Beweglichkeit der Ladungsträger gegenüber epitaktischen, undotierten Schichten (Reinst-GaAs) geringer und die Ladungsträgerlebensdauer ist durch hohe Zahl an Einfangzentren reduziert. Beides wirkt sich nachteilig auf den Durchlaßwiderstand der PIN-Diode aus und limitiert somit die Einfügungsdämpfung des Schalterbauelements. Ein weiterer Nachteil sind die Ladungsträgerkonzentrationen unterhalb der P- und N-Kontaktzonen, die aufgrund der ungünstigen elektrischen Feldverteilung unterhalb der Kontaktzonen während des Ausschaltvorgangs nicht effizient abgebaut werden. Dies begrenzt die Ausschaltzeit der Diode, da die Träger in diesen Bereichen praktisch nur über intrinsische Ladungsträgerrekombinationsprozesse entfernt werden können. Dieses nachteilige Verhalten ist analog zu optoelektronischen Metall-Halbleiter-Metall (MSM) Photodetektoren, bei denen unterhalb der Schottkykontakte nur eine schwache, laterale elektrische Feldkompenente existiert und somit die photoempfindlichen Träger nur sehr ineffizient abgesaugt werden.

Aufgabe der Erfindung ist es deshalb ein Verfahren zur Herstellung von PIN-Dioden und eine entsprechende PIN-Diode anzugeben, so daß kostengünstige und leistungsfähige integrierte Schaltungen in planarer und integrationsfähiger Ausführung mit sehr kurzen Schaltzeiten, geringen Einfügungsdämpfungen und hohen Isolationswiderständen herstellbar sind.

Die Aufgabe wird gelöst durch die in den Patentansprüchen 1 und 4 angegebenen Merkmale. Vorteilhafte Ausgestaltungen und Weiterbildungen sind den Unteransprüchen zu entnehmen.

Es wird eine vorteilhafte Bauelementanordnung für eine planare, laterale PIN-Diode auf der Basis von GaAs-Material vorgeschlagen, die sich durch eine sehr schnelle Schaltzeit und gleichermaßen geringe Durchgangsdämpfung auszeichnet und mit einem kostengünstigen Herstellungsverfahren realisiert werden kann. Dabei findet der Stromtransport in einer epitaktisch hergestellten I-Schicht statt (vorteilhafterweise mit MBE hergestellt), die nominell undotiert ist. Die Substrattemperatur während des Wachstums für die I-Schicht liegt, üblicherweise im Bereich zwischen 500°C und 700°C. Derartige Schichten haben eine sehr geringe Restverunreinigungskonzentration zwischen $10^{13}$cm$^{-3}$ und $10^{14}$cm$^{-3}$. Damit werden höchste Beweglichkeitswerte von ca. 8500 cm$^2$/Vs für Elektronen und ca. 400cm$^2$/Vs für Löcher erreicht. Die mittlere Ladungsträgerlebensdauer liegt im Bereich von einer Nanosekunde. Somit wird ein kleiner Diodenserienwiderstand in Durchlaßrichtung der Diode erreicht, der sich wie folgt abschätzen läßt:

$$R_s = W^2/2\mu I_F \tau$$

wobei $R_s$ der Serienwiderstand, W die effektive Länge der I-Schicht zwischen den P- und N-Kontakten, $\mu$ die mittlere Ladungsträgerbeweglichkeit, $I_F$ der in Flußrichtung fließende Strom und $\tau$ die mittlere Ladungsträgerlebensdauer ist. Ein kleiner Serienwiderstand wirkt sich direkt auf eine günstige Eingangsdämpfung eines HF-Schalters aus. Die P- und N-Bereiche der Diode werden über ein Implantationsverfahren direkt in der epitaktischen I-Schicht erzeugt. Somit ist die Struktur in vorteilhafterweise planar und günstig für eine Integration und vermeidet den Einsatz einer Luftbrückentechnologie.

Weiterhin werden offene Mesakanten vermieden, was sich vorteilhafterweise auf die Lebensdauer des Bauelements auswirkt und eine technologisch komplizierte Passivierung an den hohen, seitlichen Mesakanten von vertikalen PIN-Dioden, vermeidet.

Ein weiterer Vorteil besteht darin, daß zusätzlich zur stromführenden I-Schicht eine weitere, unterhalb der I-Schicht und unterhalb der P- und N-Kontaktzonen liegende, zusätzliche GaAs-Schicht angeordnet ist. Diese Schicht ist ebenfalls nominell undotiert, zeichnet sich aber dadurch aus, daß die Schicht bei niedrigen Substrattemperaturen im Bereich von nur ca. 200°C abgeschieden wird (sog. Low-Temperature-Grown=LTG) und daß während dem Abscheideprozeß der Halbleiter geringfügig mit Arsen angereichert wird, im Bereich von wenigen Prozent Überschuß an Arsen (nichtstöchiometrischer Halbleiter) und anschließend bei ca. 600°C thermisch ausgeheilt wird. Diese Ausheilung erfolgt vorteilhafterweise innerhalb der Epitaxieanlage während der Abscheidung der darüberliegenden Schichten. Auf diese Weise entsteht ein GaAs-Material mit neuartigen Eigenschaften. Insbesondere hat die LTG-Schicht eine extrem kurze, mittlere Ladungsträgerlebensdauer zwischen 0,1 und 0,2 Nanosekunden im Gegensatz zu 1 Nanosekunde bei konventionell hergestelltem GaAs und Wachstumstemperaturen zwischen 500°C und 700°C. Außerdem zeichnet sich die LTG-GaAs Schicht durch einen sehr hohen Isolationswiderstand und eine erhöhte elektrische Durchbruchsfeldstärke aus, im Vergleich zu konventionell hergestelltem, epitaktischen und stöchiometrischem GaAs.

Mit dieser Zweischichtanordnung wird im Durchflußbereich der Strom in lateraler Richtung niederohmig innerhalb der I-Zone zwischen den P- und N-Kontaktzonen geführt. Während des Ausschaltvorgangs werden die Ladungsträger sehr schnell in der darunterliegenden LTG-Schicht rekombinieren und über die Kontaktzonen lateral aus der I-Zone abgesaugt. Ein besonderer Vorteil der Anordnung liegt darin, daß die Ladungsträgerkonzentration unterhalb der P- und N-Kontaktzonen, die sich in einem Bereich eines ungünstigen, niedrigeren, lateralen elektrischen Feldes befinden und in der LTG-Schicht sehr schnell rekombinieren. Dadurch wird insgesamt ein schnellerer Ausschaltvorgang erreicht, ohne daß die Flußcharakteristik der Diode nachteilig beeinflußt wird.

Ferner werden die elektrischen Feldlinien durch den Unterschied in den spezifischen Widerständen der beiden Schichten (I-Schicht: 10 Ωcm bis 300 Ωcm, LTG-Schicht: $10^6$ Ωcm bis $10^9$ Ωcm) in günstigerweise in lateraler Richtung konzentriert, was sich ebenfalls in vorteilhafterweise auf das Transportverhalten des Bauelements auswirkt.

Die Erfindung wird anhand eines Ausführungsbeispiels unter Bezugnahme auf schematische Zeichnungen im folgenden näher erläutert.

In Fig. 1 ist der Schichtaufbau der PIN-Diode dargestellt.

Fig. 2 zeigt die Herstellung der P- und N-Kontaktbereiche.

Fig. 3 zeigt die Kontaktierung der P- und N-Bereiche.

Fig. 4 stellt geeignete Kontaktgeometrien für die PIN-Diode dar.

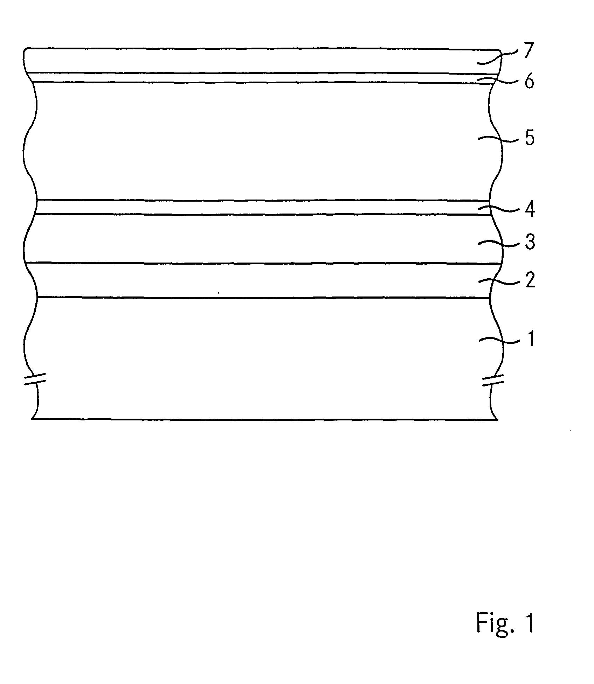

In Fig. 1 ist der vertikale Schichtaufbau schematisch dargestellt. Als Substrat wird ein kommerziell erhältliches, kompensiertes GaAs-Substrat 1 (halbisolierend, $10^7$ $\Omega$cm bis $10^8$ $\Omega$cm) verwendet. Mit Hilfe einer Epitaxiemethode, vorzugsweise Molekularstrahlepitaxie (MBE), werden die einzelnen Halbleiterschichten 2, 3, 4, 5, 6 und 7 in einem zusammenhängenden Prozeßschritt nacheinander abgeschieden. Alle Schichten sind nominell undotiert. Die Substrattemperatur liegt bis auf die Abscheidung der Schicht 3 zwischen 500°C und 700°C. Die Schichten sind alle stöchiometrisch in ihrer Zusammensetzung, außer der LTG-Schicht 3, die mit Arsenüberschuß hergestellt ist (nicht stöchiometrisch). Die Abscheidung der Schicht 3 erfolgt bei tiefer Substrattemperatur bei ca. 200°C. Hierzu wird vorteilhafterweise nach der Abscheidung von Schicht 2 das Wachstum unterbrochen, die Substrattemperatur abgesenkt und danach Schicht 3 abgeschieden. Danach wird das Wachstum erneut unterbrochen, um die Temperatur wieder hochzufahren und anschließend Schicht 4 und die folgenden Schichten 5, 6 und 7 bei der hohen Substrattemperatur abzuscheiden. Während dieses Prozeßes heilt dann auch die LTG-Schicht (3) aus und es werden die o.g. vorteilhaften Materialeigenschaften erzeugt.

Eine beispielhafte Schichtenfolge ist:

- eine undotierte Pufferschicht 2, vorzugsweise aus GaAs-Material und einer AlGaAs/GaAs-Übergitterstruktur mit einer Gesamtdicke im Bereich zwischen 10 nm und 200 nm

- eine LTG-GaAs Schicht 3 mit einer Dicke zwischen 10 nm und 100 nm, abgeschieden bei tiefer Substrattemperatur

- eine Diffusionsbarrierenschicht 4 in Form von AlAs, AlGaAs, GaInP oder einer geeigneten Übergitterstruktur aus den genannten Materialien mit einer beispielhaften Dicke zwischen 5 nm und 20 nm

- eine, die laterale Diode bildende, stromführende I-Schicht 5 aus GaAs mit einer beispielhaften Dicke zwischen 0,4 $\mu$m und 0,8 $\mu$m

- eine Ätzstopschicht 6, beispielsweise in Form von AlAs, AlGaAs oder GaInP mit einer Dicke zwischen 2 nm und 10 nm

- eine Schutzschicht 7, beispielsweise in Form von GaAs mit einer Dicke zwischen 10 nm und 50 nm.

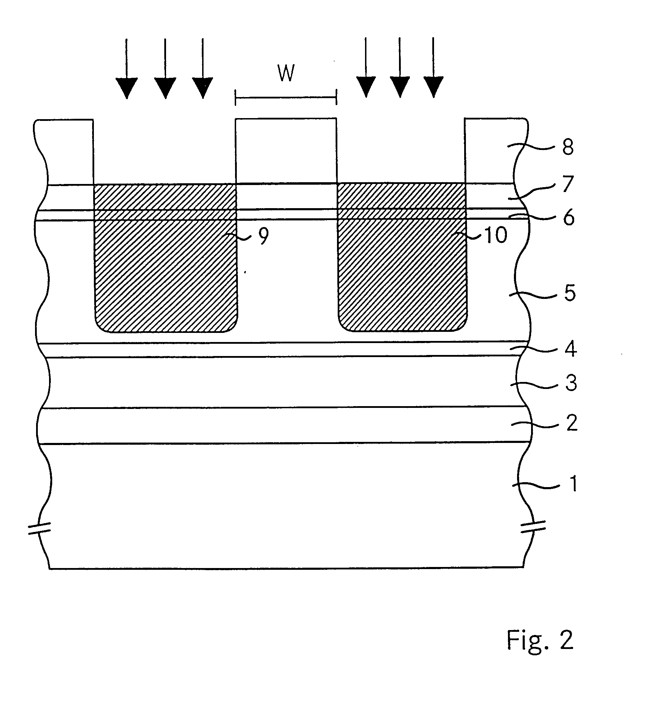

Für die Herstellung eines planaren Bauelements erfolgt zunächst eine selektive Implantation zur Erzeugung des P-leitenden Bereichs 9 und des N-leitenden Bereichs 10 wie in Fig. 2 schematisch dargestellt. Hierzu wird die Halbleiterscheibe mit einer z.B. dielektrischen Schicht 8 abgedeckt, vorteilhafterweise mit $Si_3N_4$ oder $SiO_2$. Die Dicke der Schicht wird so gewählt, daß die während des Implantationsprozeß auftreffenden Ionen vollständig absorbiert werden. Die Dicke der Schicht 8 liegt im Bereich zwischen 2 $\mu$m und 3 $\mu$m. Mit photolithographischen Verfahren wird die dielektrische Kappe selektiv mit Ätzverfahren geöffnet. Die Ionenimplantation erfolgt dann zur Erzeugung eines N-Kontaktbereichs. Für die Erzeugung des P-Bereichs wird der Vorgang entsprechend wiederholt.

Als Ionen für die N-Bereiche verwendet man beispielsweise Siliziumionen ($Si^+$) mit einer beispielhaften Gesamtdosis von $2\times10^{14}$cm$^{-2}$ mit Implantationsdosen von 320 keV ($1,5\times10^{14}$cm$^{-2}$), 120 keV ($4\times10^{13}$cm$^{-2}$) und 40 keV ($1,5\times10^{13}$ cm$^{-2}$). Als Ionen für die P-Bereiche verwendet man beispielsweise Magnesiumionen ($Mg^+$) mit einer beispielhaften Gesamtdosis von einigen $10^{15}$cm$^{-2}$. Die Energieabstufungen und relativen Dosisverhältnisse sind ähnlich wie bei der Si-Implantation, da die Atommassen der beiden Elemente ähnlich sind. Die Kontaktbereiche sollten bis nahe an die Diffusionsbarrieren/LTG-Schicht (4), (3) heranreichen. Die erreichbaren Ladungsträgerdichten betragen beispielsweise über $3\times10^{18}$ cm$^{-3}$ für den N- und über $5\times10^{19}$ cm$^{-3}$ für den P-Bereich.

Generell sind andere Ionensorten für die P- und N-Kontaktbereiche verwendbar, etwa Be, C, S, Se, etc. Die Energien und die relativen Dosisverhältnisse sind im allgemeinen so aufeinander abzustimmen, daß die Tiefenprofile der P- und N-Ionenverteilung möglichst gleich sind. Durch höhere Ionenenergien und Ionendosen läßt sich die Tiefe der Kontaktbereiche erhöhen und die Leitfähigkeit steigern, was sich vorteilhaft auf den Serienwiderstand der PIN-Diode auswirkt.

Die Aktivierung der Ionen erfolgt durch einen Ausheilschritt bei hohen Temperaturen, etwa im Bereich zwischen 800°C und 900°C, wobei die Halbleiterscheibenoberfläche mit einer Schutzkappe abgedeckt ist, um einer Oberflächendegradation vorzubeugen, beispielsweise mit SiON oder $SiO_2$ mit einer Dicke im Bereich zwischen 50 nm und 200 nm.

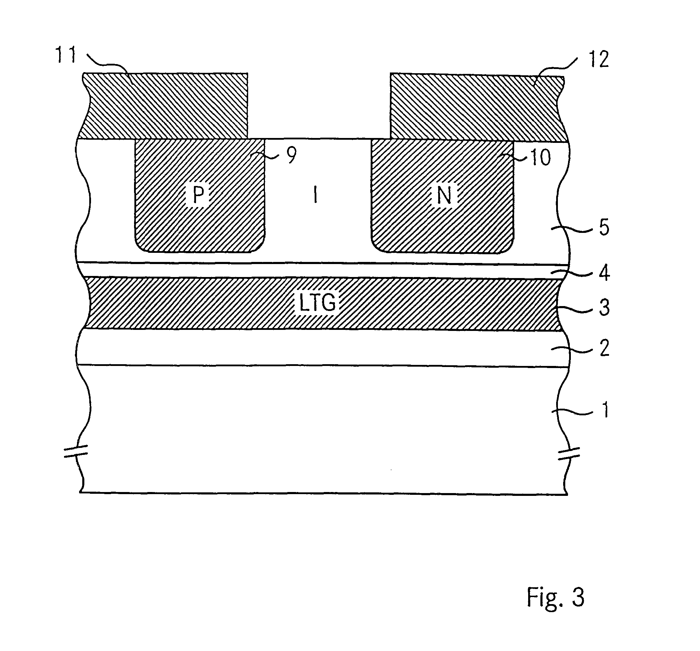

Für das Aufbringen der Kontaktmetallisierung an die P- und N-leitenden Bereiche wird zuerst die GaAs-Schutzschicht 7 ganzflächig selektiv entfernt und danach die Ätzstopschicht 6 ganzflächig selektiv entfernt. Danach wird über photolithographische Verfahren die Kontaktmetallisierung für den P-leitenden Kontakt 11 und den N-leitenden Kontakt 12 aufgebracht, z.B. eine Metallschichtenfolge aus Ti/Pt/Au für den P-Kontakt und beispielsweise Ge/Ni/Au für den N-Kontakt (Fig. 3). Mit einem Temperschritt bei ca. 400°C werden die Kontakte gemeinsam einlegiert.

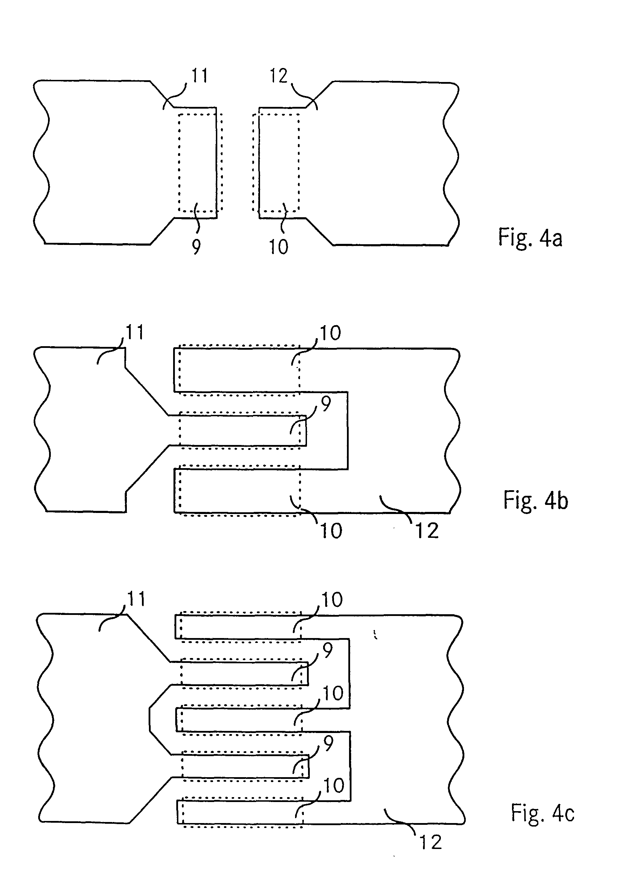

Beispielhafte Kontaktgeometrien sind in den Fig. 4a, 4b und 4c dargestellt. Einfachfinger- bzw. Mehrfachfingergeometrien sind besonders vorteilhaft für einen geringen Serienwiderstand und um den Spreading-Resistance Effekt zu reduzieren.

**Patentansprüche**

1. Verfahren zur Herstellung einer planaren PIN-Diode aus III-V-Halbleitermaterial mit lateral angeordneten P-, I- und N-Bereichen, wobei

   - auf einem halbisolierenden Halbleitersubstrat eine Halbleiterschichtenfolge epitaktisch aufgewachsen wird, die eine I-Schicht (5) enthält,
   - die P- und N-Kontaktbereiche (9, 10) in die epitaktisch gewachsene I-Schicht (5) implantiert werden,
   - die Halbleiterschichten der Halbleiterschichtenfolge stöchiometrisch in ihrer Zusammensetzung hergestellt werden bis auf eine unterhalb der I-Schicht (5) angeordnete Halbleiterschicht (3), die nicht stöchiometrisch in ihrer Zusammensetzung ist und epitaktisch gewachsen wird,
   - die nicht stöchiometrische Halbleiterschicht (3) während der Abscheidung der nachfolgenden Halbleiterschichten thermisch ausgeheilt wird, **dadurch gekennzeichnet, daß**
   - zwischen der nichtstöchiometrischen Halbleiterschicht (3) und der I-Schicht (5) eine Diffusionsbarrierenschicht (4) eingebracht wird.

2. Verfahren nach Anspruch 1, **dadurch gekennzeichnet, daß** die Halbleiterschichtenfolge aus III/V-Halbleiterverbindungen hergestellt wird, und daß die Wachstumstemperaturen der stöchiometrischen Halbleiterschichten zwischen 500°C und 700°C liegen und die der nicht stöchiometrischen Halbleiterschicht bei etwa 200°C liegt.

3. Verfahren nach Anspruch 2, **dadurch gekennzeichnet, daß** als III/V-Halbleiterverbindung GaAs verwendet wird, wobei die nicht stöchiometrische Halbleiterschicht (3) geringfügig mit Arsen angereichert wird.

4. Planare PIN-Diode aus III-V-Halbleitermaterial mit lateral angeordneten P-, I- und N-Bereichen, **dadurch gekennzeichnet, daß** auf einem halbisolierenden GaAs-Substrat (1) eine Halbleiterschichtenfolge aufgebracht ist, die aus

   - einer undotierten Pufferschicht (2) aus GaAs und einer AlGaAs/GaAs-Übergitterstruktur mit einer Schichtdicke zwischen 10 nm und 200 nm,
   - einer GaAs-Schicht (3) mit einem etwa 1% Überschuß an As und einer Schichtdicke zwischen 10 nm und 100 nm,
   - einer Diffusionsbarrierenschicht (4) aus AlAs oder AlGaAs oder GaInP oder einer Übergitterstruktur aus AlAs, AlGaAs, GaInP mit einer Schichtdicke zwischen 5 nm und 20 nm,
   - einer, die laterale Diode bildende, stromführende I-Schicht (5) aus mit einer Schichtdicke zwischen 0.4 μm und 0.8 μm,
   - in die I-Schicht (5) lateral angeordnete implantierte P- und N-Bereiche (9, 10), auf die der P-leitende Kontakt (11) und der N-leitende Kontakt (12) aufgebracht ist.

5. PIN-Diode nach Anspruch 4, **dadurch gekennzeichnet, daß** die GaAs-Schicht (3) einen spezifischen Widerstand von $10^6$ bis $10^9$ Ωcm besitzt.

**Claims**

1. Method for fabricating a planar PIN diode made of III-V semiconductor material with laterally arranged P, I and N regions, in which case

   - a semiconductor layer sequence containing an I layer (5) is grown epitaxially on a semi-insulating semiconductor substrate,
   - the P and N contact regions (9, 10) are implanted into the epitaxially grown I layer (5),
   - the semiconductor layers of the semiconductor layer sequence are fabricated stochiometrically in their composition except for a semiconductor layer (3) arranged below the I layer (5), the said semiconductor layer not being stochiometric in its composition and being grown epitaxially,
   - the non-stochiometric semiconductor layer (3) is thermally annealed during the deposition of the subsequent semiconductor layers,

   **characterized in that**

   - a diffusion barrier layer (4) is introduced between the non-stochiometric semiconductor layer (3) and the I layer (5).

2. Method according to Claim 1, **characterized in that** the semiconductor layer sequence is fabricated from III-V semiconductor compounds, and **in that** the growth temperatures of the stochiometric semiconductor layers lie between 500°C and 700°C and that of the non-stochiometric semiconductor layer is about 200°C.

3. Method according to Claim 2, **characterized in that** GaAs is used as the III-V semiconductor compound, the non-stochiometric semiconductor layer (3) being slightly enriched with arsenic.

**4.** Planar PIN diode made of III-V semiconductor material with laterally arranged P, I and N regions, <u>**characterized in that**</u> a semiconductor layer sequence is applied on a semi-insulating GaAs substrate (1), which sequence comprises

- an undoped buffer layer (2) made of GaAs and an AlGaAs/GaAs superlattice structure having a layer thickness between 10 nm and 200 nm,
- a GaAs layer (3) having approximately a 1% excess of As and a layer thickness between 10 nm and 100 nm,
- a diffusion barrier layer (4) made of AlAs or AlGaAs or GaInP or a superlattice structure made of AlAs, AlGaAs, GaInP having a layer thickness between 5 nm and 20 nm,
- a current-carrying I layer (5), forming the lateral diode, made of [lacuna] having a layer thickness between 0.4 $\mu$m and 0.8 $\mu$m,
- implanted P and N regions (9, 10) arranged laterally in the I layer (5), to which regions the P-conducting contact (11) and the N-conducting contact (12) are applied.

**5.** PIN diode according to Claim 4, **characterized in that** the GaAs layer (3) has a resistivity of $10^6$ to $10^9$ $\Omega$cm.

**Revendications**

**1.** Méthode de fabrication d'une diode PIN plane en matériau semiconducteur III-V avec des zones P, I et N disposées latéralement, avec laquelle

- une série de couches semiconductrices qui contient une couche I (5) est déposée en phase vapeur de manière épitaxiale sur un substrat semiconducteur à moitié isolé,
- les zones de contact P et N (9, 10) sont implantées dans la couche I (5) déposée en phase vapeur de manière épitaxiale,
- les couches semiconductrices de la série de couches semiconductrices sont réalisées de manière à présenter une composition stoechiométrique, à part une couche semiconductrice (3) disposée sous la couche I (5) dont la composition n'est pas stoechiométrique et qui est déposée en phase vapeur de manière épitaxiale,
- la couche semiconductrice non stoechiométrique (3) est excitée par voie thermique pendant le dépôt en phase vapeur des couches semiconductrices suivantes, **caractérisée en ce que**
- une couche de barrière de diffusion (4) est insérée entre la couche semiconductrice non stoechiométrique (3) et la couche I (5).

**2.** Méthode selon la revendication 1, **caractérisée en ce que** la série de couches semiconductrices est fabriquée avec des liaisons semiconductrices III/V et que les températures de croissance des couches semiconductrices stoechiométriques sont comprises entre 500°C et 700°C et celle de la couche semiconductrice stoechiométrique est d'environ 200°C.

**3.** Méthode selon la revendication 2, **caractérisée en ce que** la liaison semiconductrice III/V utilisée est du GaAs, la couche semiconductrice stoechiométrique (3) étant légèrement enrichie avec de l'arsenic.

**4.** Diode PIN plan en matériau semiconducteur III-V avec des zones P, I et N disposées latéralement, **caractérisée en ce qu'**une série de couches semiconductrices est déposée en phase vapeur de manière épitaxiale sur un substrat de GaAs (1) à moitié isolée, laquelle se compose de:

- une couche tampon non dopée (2) en GaAs et une structure de surgrille en AlGaAs/GaAs ayant une épaisseur de couche comprise entre 10 nm et 200 nm,
- une couche de GaAs (3) comprenant environ 1% d'excédent d'As et une épaisseur de couche comprise entre 10 nm et 100 nm,
- une couche de barrière de diffusion (4) en AlAs ou en AlGaAs ou en GaInP ou une structure de surgrille en AlAs, AlGaAs, GaInP et une épaisseur de couche comprise entre 5 nm et 20 nm,
- une couche I (5) conductrice d'électricité, formant la diode latérale, avec une épaisseur de couche comprise entre 0,4 $\mu$m et 0,8 $\mu$m,
- des zones P et N (9, 10) implantées latéralement dans la couche I (5) et sur lesquelles sont implantés le contact conducteur P (11) et le contact conducteur N (12).

**5.** Diode PIN selon la revendication 4, **caractérisée en ce que** la couche de GaAs (3) possède une résistance spécifique comprise entre $10^6$ et $10^9$ $\Omega$cm.

Fig. 1

Fig. 2

Fig. 3

Fig. 4a

Fig. 4b

Fig. 4c